# EUROPÄISCHE PATENTSCHRIFT

(11) **EP 1 709 842 B1**
(45) Veröffentlichungstag und Bekanntmachung des Hinweises auf die Patenterteilung: **21.10.2009**
(21) Anmeldenummer: 05714905.6
(22) Anmeldetag: 28.01.2005
(51) Int. Cl.: H05B 41/02, H05B 39/00, F21V 23/02, H05K 5/00

(54) **VORSCHALTGERÄTEKASTEN**
BOX FOR A BALLAST
BOITIER DE BALLAST

(30) Priorität: 30.01.2004 DE 202004001374
(43) Veröffentlichungstag der Anmeldung: 11.10.2006
(73) Patentinhaber: TRILUX GmbH & Co. KG, 59759 Arnsberg (DE)
(72) Erfinder: DREES, Frank, 58840 Plettenberg (DE)
(74) Vertreter: Bobzien, Hans Christoph
(86) Internationale Anmeldenummer: PCT/DE2005/000128
(87) Internationale Veröffentlichungsnummer: WO 2005/074342

(56) Entgegenhaltungen:
- EP-A- 0 481 409
- US-A- 4 924 152
- US-A- 5 691 878
- US-A- 5 762 509
- US-A- 6 039 582

## Beschreibung

Die Erfindung betrifft einen Vorschaltgerätekasten mit einem Sockel zur Befestigung auf einem Untergrund, einer mit dem Sockel verbindbaren und diese in Einbaulage abdeckenden Haube und einer temperaturbeständigen Adapterplatte zur Fixierung elektronischer Bauteile in dem Vorschaltgerätekasten.

Vorschaltgerätekasten sind in US-A-6 039 582 und US-A-5 762 509 offenbart.

Derartige Vorschaltgerätekästen werden vorzugsweise dazu eingesetzt, Vorschaltgeräte in Decken getrennt von den einzelnen Leuchten einzubauen, um die Vorschaltgeräte aus dem eigentlichen Leuchtengehäuse herauszuhalten und damit aufgrund ihrer Größe die Baugröße des Leuchtengehäuses kleiner gestalten zu können. Die Verbindung des Vorschaltgerätekastens mit dem Leuchtengehäuse und der darin angeordneten Leuchtmittel erfolgt normalerweise über ein Kabel.

Bei derartigen Vorschaltgerätekästen tritt das Problem auf, dass induktive Vorschaltgeräte im Kern höhere Temperaturen von bis zu 350°C oder mehr entwickeln können. Diese Temperatur kann bewirken, dass ein aus einem thermoplastischen Kunststoff bestehender Vorschaltgerätekasten schmilzt; zumindest kann sich jedoch die Lage des Vorschaltgerätes in dem Vorschaltgerätekasten verändern. Nach einer VDE-Richtlinie ist eine derartige Lageveränderung elektronischer Aggregate, insbesondere von Vorschaltgeräten, nicht zulässig. Zur Vermeidung dieser ungewünschten Lageveränderungen kann der Vorschaltgerätekasten aus einem temperaturbeständigem Material, wie zum Beispiel Metall oder einem Douroplast gefertigt werden; ferner können entsprechende kostenintensive Kühlvorrichtungen vorgesehen werden. Derartig ausgebildete Vorschaltgerätekästen sind jedoch relativ teuer. Insgesamt ist es jedoch wünschenswert; induktive anstelle von elektronischen Vorschaltgeräten einzusetzen, da induktive Vorschaltgeräte erheblich kostengünstiger als elektronische sind.

Erfindungsgemäß soll ein Vorschaltgrätekasten vorgesehen werden, der zum einen kostengünstig ist, gleichzeitig aber so ausgebildet ist, dass keine Lageveränderung eines induktiven Vorschaltgerätes in dem Vorschaltgerätekasten auch bei starker Erwärmung auftritt.

Diese Aufgabe wird erfindungsgemäß dadurch gelöst, dass in dem Sockel mindestens eine Durchdringungsöffnung vorgesehen ist und dass ein temperaturbeständiges Distanzstück vorgesehen ist, das in Einbaulage in die Durchdringungsöffnung einsetzbar und auf das die Adapterplatte in Einbaulage aufsetzbar ist. Das temperaturbeständige Distanzstück ist aus einem Material gefertigt, das mindestens der in einem induktiven Vorschaltgerät auftretenden Kerntemperaturen ohne geometrische Veränderungen standhält. Das Distanzstück kann zum Beispiel aus einem Metall oder einem Douroplast gefertigt sein. Im Rahmen der Montage wird dieses Distanzstück zwischen der temperaturbeständigen Adapterplatte, auf welcher das induktive Vorschaltgerät montiert ist, und dem Untergrund montiert, auf den der Vorschaltgerätekasten befestigt ist oder aufsitzt. Dabei wird das Distanzstück in die Durchdringungsöffnung des Sockels eingesetzt und durchdringt somit den Sockel, um unmittelbar auf dem Untergrund aufzusitzen. Im Falle einer starken Erhöhung der Temperatur des Vorschaltgerätes kommt es auch bei einer Gestaltsveränderung des Vorschaltgerätekastens nicht zu einer Lageveränderung des Vorschaltgerätes; die VDE-Richtlinie ist mithin durch den erfindungsgemäßen Vorschaltgerätekasten eingehalten.

Vorzugsweise ist das Distanzstück unmittelbar an der Adapterplatte vorgesehen, um eine zusätzliche Montageschritte zu vermeiden.

Als besonders vorteilhaft hat sich herausgestellt, die Adapterplatte als Adapterblech auszubilden und an diesem Adapterblech mehrere Distanzstücke vorzusehen; beispielsweise können die Distanzstücke als einzelne Laschen unmittelbar an dem Adapterblech ausgebildet sein. Im Einzelfall sind diese als Distanzstücke fungierenden Laschen umbiegbar ausgestaltet.

Daneben kann auch der erfindungsgemäße Vorschaltgerätekasten eine weitere Abdeckung zur Abdeckung der Anschlusselemente aufweisen, die getrennt von der Haube lösbar mit dem Sockel verbindbar ist.

Die Erfindung wird nachfolgend anhand eines bevorzugten Ausführungsbeispieles beschrieben, wobei auf die beigefügten Zeichnungen Bezug genommen wird. In diesen zeigen:
- Figur 1:: Eine perspektivische Ansicht des erfindungsgemäßen Vorschaltgerätekastens;
- Figur 2:: eine perspektivische Ansicht des Sockels von oben;
- Figur 3:: eine vergrößerte Ansicht des Details III. aus Figur 2;
- Figur 4:: eine vergrößerte Ansicht des Details IV. aus Figur 2;
- Figur 5:: eine perspektivische Ansicht des Sockels von unten;
- Figur 6:: eine perspektivische Ansicht der Haube;
- Figur 7:: eine perspektivische Ansicht der Abdeckung und
- Figur 8:: eine perspektivische Ansicht des erfindungsgemäßen Adapterblechs.

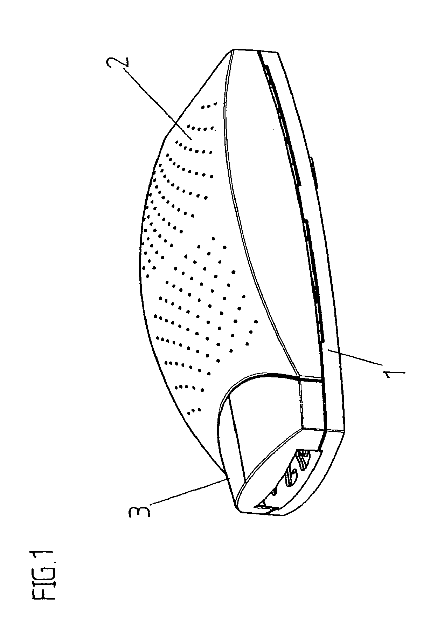

Demnach besteht der Vorschaltgerätekasten aus einem Sockel 1, eine lösbar auf den Sockel aufsetzbaren Haube 2 und einem ebenfalls lösbar mit dem Sockel 1 befestigbaren Abdeckung 3. Sowohl die Haube 2 als auch die Abdeckung 3 sind domartig ausgebildet und überspannen den Sockel 1, um somit zwischen der Oberseite des Sockels 1 und der Haube 2 und der Abdeckung 3 einen Einbauraum zur Aufnahme der Vorschaltgeräte und anderer elektronischer Aggregate vorzusehen. Innerhalb dieser Räume ist eine in der Figur 1 nicht sichtbares Adapterblech 4 angeordnet (siehe Fig. 8). Die Abdeckung 3 überspannt den Anschlussbereich des Vorschaltgerätekastens zum Anschließen der nicht dargestellten Kabel.

Für die Fertigung eines solchen Vorschaltgerätekastens werden vorzugsweise thermoplastische Kunststoffe, insbesondere PC, ABS, PA, PBT, POM und ihre Blends sowie weitere Thermoplaste eingesetzt. Die Teile werden entweder gespritzt oder geformt.

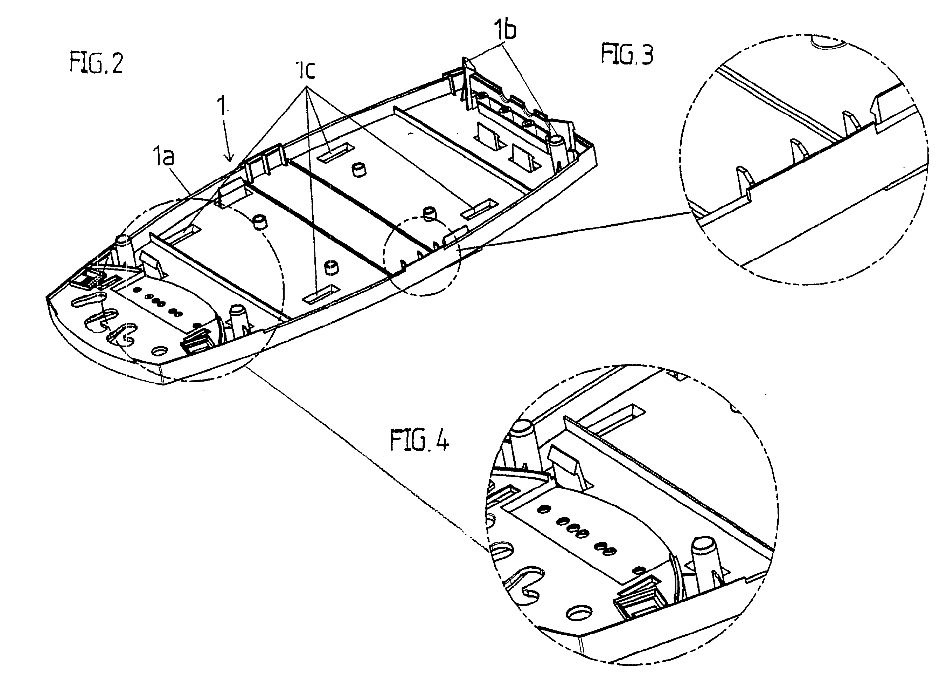

Gemäß den Figuren 2 bis 4 besteht der Sockel 1 aus einem plattenförmigen Element mit einem umlaufenden Längsrand 1a, der in Einbaulage quer zur Fläche des Sockels 1 nach oben steht. Am vorderen und hinteren Bereich des Sockels 1 sind jeweils zwei Rasthaken 1b einstückig eingeformt, die von der Fläche des Sockels 1 quer nach oben ragen. Diese Rasthaken 1b sind an ihren oberen Enden mit Ratsvorsprüngen versehen, die in Einbaulage in entsprechende Hinterschnitte an der Haube 2 eingreifen.

Im Boden des Sockels sind beabstandet voneinander insgesamt vier Durchdringungsöffnungen 1c vorgesehen, die jeweils eine rechteckige Geometrie aufweisen.

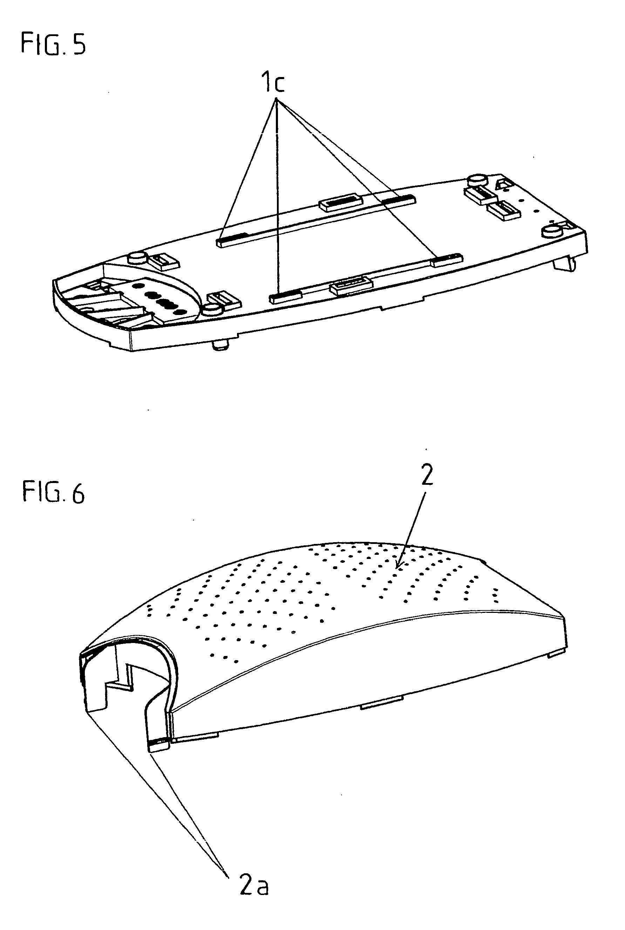

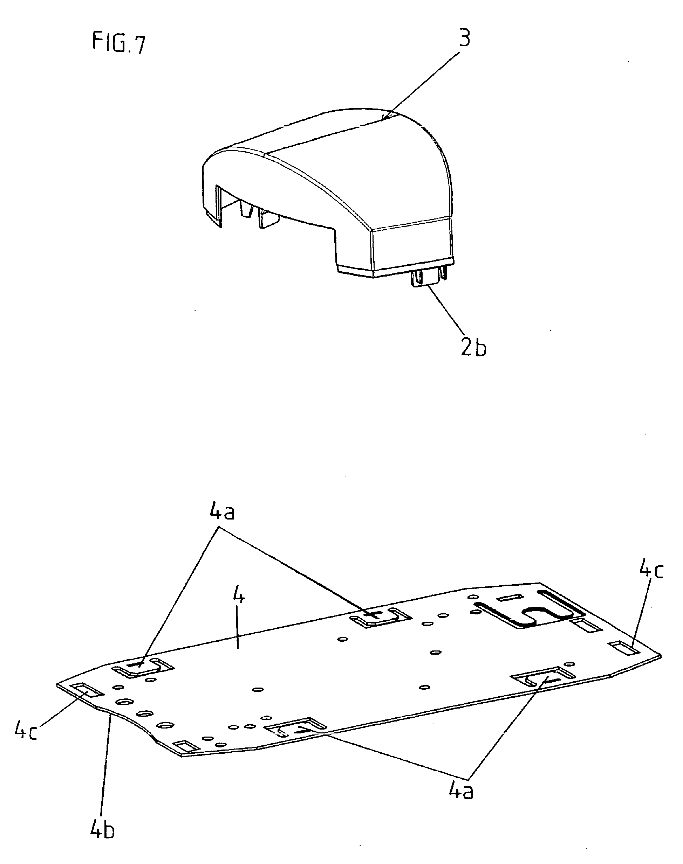

Aus den Figuren 6 und 7 ist zu entnehmen, dass sowohl die Haube 2 als auch die Abdeckung 3 ebenfalls jeweils mit einteilig angeformten Rasthaken 2a bzw. 2b zur Verbindung und zum Einrasten in entsprechende Öffnungen an dem Sockel 1 ausgebildet sind.

Figur 5 zeigt eine perspektivische Ansicht der erfindungsgemäßen Adapterplatte 4 zur Fixierung eines induktiven Vorschaltgerätes (nicht dargestellt) in den Vorschaltgerätekasten. Zu diesem Zweck wird das Vorschaltgerät auf der Oberfläche der Adapterplatte 4 befestigt.

Die aus einem Metallblech gestanzte Adapterplatte 4 ist mit verschiedenen Öffnungen und Löchern versehen. Wesentlich für die Erfindung sind die vier, beabstandet voneinander am Randbereich ausgestanzten Laschen 4a, welche die Funktion der erfindungsgemäßen Distanzstücke erfüllen. Diese Laschen 4a werden bei der Montage aus der in Figur 8 dargestellten Stellung um 90° aus der Ebene der Adapterplatte 4 nach unten gebogen. Die Laschen können nun beim Einsetzen der Adapterplatte 4 auf den Sockel 1 in die Durchdringungsöffnungen 1c des Sockels eingesetzt werden und sitzen somit in Einbaulage unmittelbar auf dem Untergrund auf. An den stirnseitigen Enden der Adapterplatte sind verschiedene Bohrungen 4b zum Erden der Verbindungsklemmen vorgesehen. Ferner weist die Adapterplatte an den Stirnenden längliche Öffnungen 4c auf, die als Hinterschnitte für den Eingriff von der für die Montage der Adapterplatte am Sockel 1 vorgesehenen Rasthaken dienen.

Auch wenn sich das induktive Vorschaltgerät in dem Vorschaltgerätekasten so stark erhitzt, dass das umgebende Kunststoffgehäuse des Vorschaltgerätekastens schmilzt, verändert das Vorschaltgerät seine Lage nicht, da es auf der metallenen Adapterplatte 4 aufsitzt, die sich über die Laschen 4a unmittelbar auf dem Untergrund abstützt, ohne auf dem Sockel 1 des Vorschaltgerätekastens aufzusitzen.

### Vorschaltgerätekasten

### Bezugszeichenliste

- 1: Sockel
- 1a: Rand
- 1b: Rasthaken
- 1c: Durchdringungsöffnung
- 2: Haube
- 2a: Rasthaken
- 3: Abdeckung
- 3b: Rasthaken
- 4: Adapterplatte
- 4a: Lasche
- 4b: Bohrung
- 4c: Öffnung

## Patentansprüche

1. Vorschaltgerätekasten mit einem Sockel (1) zur Befestigung auf einem Untergrund, einer mit dem Sockel (1) verbindbaren und diese in Einbaulage abdeckenden Haube (2) und einer temperaturbeständigen Adapterplatte zur Fixierung elektronischer Bauteile in dem Vorschaltgerätekasten, **dadurch gekennzeichnet, dass** in dem Sockel (1) eine Durchdringungsöffnung (1c) vorgesehen ist und dass ein temperaturbeständiges Distanzstück vorgesehen ist, das in Einbaulage in die Durchdringungsöffnung (1c) einsetzbar und auf das die Adapterplatte in Einbaulage aufsetzbar ist.

2. Vorschaltgerätekasten nach Anspruch 1, **dadurch gekennzeichnet, dass** das Distanzstück an der Adapterplatte vorgesehen sind.

3. Vorschaltgerätekasten nach Anspruch 2, **dadurch gekennzeichnet, dass** die Adapterplatte als Adapterblech (4) ausgebildet ist und dass mehrere Distanzstücke an dem Adapterblech ausgebildet sind.

4. Vorschaltgerätekasten nach Anspruch 3, **dadurch gekennzeichnet, dass** die Distanzstücke an dem Adapterblech (4) ausgebildete Laschen (4c) aufweisen.

5. Vorschaltgerätekasten nach einem der vorhergehenden Ansprüche, **dadurch gekennzeichnet, dass** dieser eine Abdeckung (3) aufweist, die lösbar mit dem Sockel (1) verbindbar ist.

## Claims

1. A ballast box comprising a base (1) for fixing to a substructure, a cap (2) which can be connected to the base (1) and which covers it in the installation position and a temperature-resistant adaptor plate for fixing electronic components in the ballast box, **characterised in that** a passage opening (1c) is provided in the base (1) and there is provided a temperature-resistant spacer portion which in the installation position can be fitted into the passage opening (1c) and on to which the adaptor plate can be fitted in the installation position.

2. A ballast box according to claim 1 **characterised in that** the spacer portion is provided on the adaptor plate.

3. A ballast box according to claim 2 **characterised in that** the adaptor plate is in the form of an adaptor sheet portion (4) and that a plurality of spacer portions are provided on the adaptor sheet portion.

4. A ballast box according to claim 3 **characterised in that** the spacer portions have tongues (4a) which are provided on the adaptor sheet portion (4).

5. A ballast box according to one of the preceding claims **characterised in that** it has a cover (3) which can be releasably connected to the base (1).

## Revendications

1. Boîtier de ballast, comportant un socle (1) à fixer sur une base, un couvercle (2) pouvant être relié au socle (1) et le couvrant en position de montage et une plaque d'adaptation thermorésistante pour fixer des composants électroniques dans le boîtier de ballast, **caractérisé en ce que** dans le socle (1), il est prévu un orifice de passage (1c) et **en ce qu'**il est prévu une pièce d'écartement thermorésistante qui peut être insérée en position de montage dans l'orifice de passage (1 c) et sur laquelle la plaque d'adaptation peut être placée en position de montage.

2. Boîtier de ballast selon la revendication 1, **caractérisé en ce que** la pièce d'écartement est prévue au niveau de la plaque d'adaptation.

3. Boîtier de ballast selon la revendication 2, **caractérisé en ce que** la plaque d'adaptation est réalisée en tant que tôle d'adaptation (4) et **en ce que** plusieurs pièces d'écartement sont réalisées au niveau de la tôle d'adaptation.

4. Boîtier de ballast selon la revendication 3, **caractérisé en ce que** les pièces d'écartement présentent des languettes (4a) réalisées au niveau de la tôle d'adaptation (4).

5. Boîtier de ballast selon l'une quelconque des précédentes revendications, **caractérisé en ce que** celui-ci présente un élément de recouvrement (3) qui peut être relié de manière amovible au socle (1).
